# EUROPEAN PATENT APPLICATION

(11) **EP 1 457 828 A2**
(43) Date of publication of application: **15.09.2004**
(21) Application number: 04075692.6
(22) Date of filing: 03.03.2004
(51) Int. Cl.: G03F 7/20, G03F 9/00

(54) **Focus spot monitoring in a lithographic projection apparatus**

(30) Priority: 10.03.2003 EP 03075698
(71) Applicant: ASML Netherlands B.V., 5503 LA Veldhoven (NL)
(72) Inventor: Van Rhee, Tasja, 5241 JP Rosmalen (NL); Castenmiller, Thomas Josephus Maria, 5616 BR Eindhoven (NL); Koenen, Willem Herman, Gertruda Anna, 60420 EC Roermond (NL); Van Zon, Alex, 5583 XH Eindhoven (NL); Broers, Michael, 5615 SP Eindhoven (NL)
(74) Representative: van Westenbrugge, Andries

(57) **Abstract**

A lithographic projection apparatus and method of manufacturing devices using said apparatus is presented, wherein the apparatus comprises a level sensor to measure the height of a wafer in a plurality of points. The height info is sent to a processor which is arranged to create a measured height map using input from the level sensor.

According to the invention the processor is also arranged to calculate an average die topology using the measured height map in order to produce a raw height map of said surface of said substrate and to detect any focus spots on said surface of said substrate using said raw height map. By subtracting the average die topology, focus spots can be located more accurately then before.

## Description

The present invention relates to a lithographic projection apparatus comprising:
- a radiation system for supplying a projection beam of radiation;
- a first object table provided with a mask holder for holding a mask;
- a second object table provided with a substrate holder for holding a substrate, the second object table;
- a projection system for imaging an irradiated portion of the mask onto a target portion of the substrate;
- a level sensor arranged to measure the height of a plurality of points on the surface of a substrate provided with at least one die, and a processor arranged to create a measured height map using input from the level sensor.

For the sake of simplicity, the projection system may hereinafter be referred to as the "lens"; however, this term should be broadly interpreted as encompassing various types of projection system, including refractive optics, reflective optics, catadioptric systems, and charged particle optics, for example. The radiation system may also include elements operating according to any of these principles for directing, shaping or controlling the projection beam, and such elements may also be referred to below, collectively or singularly, as a "lens". In addition, the first and second object tables may be referred to as the "mask table" and the "substrate table", respectively. Further, the lithographic apparatus may be of a type having two or more mask tables and/or two or more substrate tables. In such "multiple stage" devices the additional tables may be used in parallel, or preparatory steps may be carried out on one or more tables while one or more other tables are being used for exposures.

Lithographic projection apparatus can be used, for example, in the manufacture of integrated circuits (ICs). In such a case, the mask (reticle) may contain a circuit pattern corresponding to an individual layer of the IC, and this pattern can be imaged onto a particular area (die) on a substrate (silicon wafer) which has been coated with a layer of photosensitive material (resist). In general, a single wafer will contain a whole network of adjacent dies, which are successively irradiated via the reticle, one at a time. Note that instead of irradiation of only one die, several dies at once may be exposed to the radiation. Such an area which is exposed at a certain moment in time is referred to as 'exposure area'.

In one type of lithographic projection apparatus, each die is irradiated by exposing the entire reticle pattern onto the die in one go; such an apparatus is commonly referred to as a wafer stepper. In an alternative apparatus - which is commonly referred to as a step-and-scan apparatus - each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M (generally < 1), the speed V at which the wafer table is scanned will be a factor M times that at which the reticle table is scanned. More information with regard to lithographic devices as here described can be gleaned from International Patent Application WO 97/33205, for example.

Until very recently, lithographic apparatus contained a single mask table and a single substrate table. However, machines are now becoming available in which there are at least two independently moveable substrate tables; see, for example, the multi-stage apparatus described in International Patent Applications WO 98/28665 and WO 98/40791. The basic operating principle behind such multi-stage apparatus is that, while a first substrate table is at the exposure position underneath the projection system for exposure of a first substrate located on that table, a second substrate table can run to a loading position, discharge a previously exposed substrate, pick up a new substrate, perform some initial measurements on the new substrate and then stand ready to transfer the new substrate to the exposure position underneath the projection system as soon as exposure of the first substrate is completed; the cycle then repeats. In this manner it is possible to increase substantially the machine throughput, which in turn improves the cost of ownership of the machine. It should be understood that the same principle could be used with just one substrate table which is moved between exposure and measurement position.

The measurements performed on the substrate at the measurement position may, for example, include a determination of the spatial relationship (in X & Y directions) between various contemplated exposure areas on the substrate, reference markers on the substrate and at least one reference marker (e.g. fiducial) located on the substrate table outside the area of the substrate. Such information can subsequently be employed at the exposure position to perform a fast and accurate X and Y positioning of the exposure areas with respect to the projection beam. The measurements performed also include generating a map of the topology of the substrate. The map comprises a plurality of substrate height measurements, each recorded with associated X and Y co-ordinates. The map is commonly referred to as a height map.

In patent publication EP 1037117 a lithographic projection apparatus as described in the preamble is discussed. It aims to position a wafer at the optimum position for a given exposure. However, the variations in wafer surface height over the exposure area may be such that the wafer cannot be positioned to give adequate focus over the entire exposure area. Abnormal topology differences on a wafer (i.e. substrate) are called 'focus spots'. These focus spots decrease the imaging capability of the specific exposures, which may even result in an exposure failure. EP 1037117 describes a multi-stage apparatus wherein such failures can be predicted in advance and remedial action can be taken. For example, the wafer may be stripped and recoated without the detrimental effect of further processing a badly exposed wafer. Alternatively, if the predicted failure affects only one or a few devices on the wafer whilst others will be acceptable, throughput may be enhanced by skipping exposures that are predicted in advance to result in defective devices. Focus-spot detection can be derived from analysis of height maps taken. When relatively large deviations from a global wafer plane are present in a wafer height map, this could indicate focus spots due to substrate unflatness or process influences. Comparing wafer height maps from several wafers can indicate focus spots due to contamination or unflatness of the substrate table. When focus spots appear at identical or near-identical positions for different wafers, this is most likely caused by substrate holder contamination (so-called "chuck-spots"). Focus spots occurring on a single wafer may also be identified. Projections of the wafer surface above an average die surface are identified as suspected focus spots.

It is an object of the present invention to improve focus spot monitoring in a lithographic projection apparatus.

This and other objects are achieved by a lithographic projection apparatus as described in the preamble, characterized in that the processor is also arranged to calculate an average die topology using the measured height map, and to subtract the average die topology from the measured height map for dies on the substrate, to produce a raw height map of the surface of the substrate in order to detect any focus spots on the surface of the substrate using the raw height map. Subtracting an average die topology results in a height map of the substrate 'underneath' the dies, which possesses more accurate information on focus spots, than the top surface of the wafer.

The term 'height map' is intended to refer to a plurality of substrate height measurements, each recorded with associated X and Y co-ordinates.

The present invention is based on the realisation that many dies have regular structures ( e.g. DRAM), and that significantly improved focus spot detection is achieved by taking account of these structures. A height map of the entire wafer is made. Following mapping of the wafer, the regular structure of the die is determined by averaging the topologies of all the dies on the wafer to obtain an average die topology. Then the average die topology is subtracted from each die location of the measured height map, to leave a raw height map of the 'underlying' wafer.

In an embodiment the processor is arranged to:
- smooth the raw height map using a moving average principle, thereby producing a smoothed height map;
- subtract the smoothed height map from the raw height map, thereby producing a subtracted height map;
- determine at least one deviation threshold F; and
- determine focus spots as being areas in which a residual on the subtracted height map is greater than the at least one deviation threshold F.
The moving average is calculated using a relatively large (i.e. compared to the expected size of the focus spots) smoothing window which determines slow variations in the surface height. The smoothed height map is subtracted from the raw height map, and focus spots are identified as locations in which a threshold value is exceeded.

In an embodiment, the at least one deviation threshold F is defined as n · σ, where n is a predetermined value and σ is a standard deviation of all residuals for every position x, y on the subtracted height map.

In yet another embodiment, the processor is arranged to:
- remove height information from the subtracted height map of dies that overlap with the determined focus spots, thereby producing a feedback height map;
- calculate a corrected average die topology using the feedback height map,
- subtract the corrected average die topology from the feedback height map for dies on the substrate, to produce a corrected raw height map of the surface of the substrate;
- smooth the corrected raw height map using a moving average principle, thereby producing a corrected smoothed height map;
- subtract the corrected smoothed height map from the corrected raw height map, thereby producing a corrected subtracted height map;
- determine the at least one deviation threshold F;
- determine the focus spots as being areas in which a residual on the corrected subtracted height map is greater than the at least one deviation threshold F,
- repeat the above actions until a certain accuracy level is reached.
By removing the height information of the dies that are on top of a focus spot, and repeating the processing steps mentioned, obvious errors are filtered out. Obvious errors, are for example measurements errors, also known as 'flyers', local dirt on the substrate or a focus spots itself. By filtering out the obvious errors, a higher degree of accuracy can be reached.

In another embodiment, the apparatus comprises a reporting system, wherein the reporting system and the processor are arranged to report different classifications of focus spots. If relatively large focus spots occur, they may cause processing to immediately cease, while smaller focus spots only need to be reported, in for example an administration file.

In a preferred embodiment, the second object table is movable between an exposure station, at which the projection system can image the mask portion onto the substrate, and a measurement station, and wherein the apparatus comprises:
- a positioning system for moving the second object table between the exposure station and the measurement station, and
- a control unit constructed and arranged to control the position of the second object table in at least the first direction, during exposure of the target portion, in accordance with the measured height map. The multi-stage apparatus allows calculation of the focus spots before or during exposure and hence shortens the response time to a possible focus spot. The level sensor in a multi-stage apparatus may use much smaller spots, i.e. higher sensor resolution, resulting in more detail of the height maps and thus focus spots are identified more precisely.

The present invention also relates to a method of manufacturing devices using a lithographic projection apparatus comprising:
- a radiation system for supplying a projection beam of radiation;
- a first object table provided with a mask holder for holding a mask;
- a second object table provided with a substrate holder for holding a substrate; and
- a projection system for imaging irradiated portions of the mask onto target portions of the substrate;
- a level sensor arranged to measure the height of a plurality of points on the surface of a substrate provided with at least one die, and
- a processor arranged to create a measured height map using input from the level sensor,
the method comprising:
- providing a mask bearing a pattern to the first object table;
- providing a substrate having a radiation-sensitive layer to the second object table;
- imaging the irradiated portions of the mask onto the target portions of the substrate; and
- generating, for the substrate, a measured height map indicating the height of a plurality of points on the substrate surface,
characterized by:
- calculating an average die topology using the measured height map;
- subtracting the average die topology from the measured height map for dies on the substrate, to produce a raw height map of the surface of the substrate in order to detect any focus spots on the surface of the substrate using the raw height map.

In a manufacturing process using a lithographic projection apparatus according to the invention, a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemo-mechanical polishing, etc., all intended to finish off an individual layer. If several layers are required, then the whole procedure, or a variant thereof, will have to be repeated for each new layer. Eventually, an array of devices (dies) will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and exposure area", respectively.

In the present document, the terms "radiation" and "beam" are used to encompass all types of electromagnetic radiation or particle flux, including, but not limited to, ultraviolet radiation (e.g. at a wavelength of 365 nm, 248 nm, 193 nm, 157 nm or 126 nm), extreme ultraviolet radiation (EUV), X-rays, electrons and ions. Also herein, the invention is described using a reference system of orthogonal X, Y and Z directions. Further, unless the context otherwise requires, the term "vertical" (Z) used herein is intended to refer to the direction normal to the substrate or mask surface, rather than implying any particular orientation of the apparatus.

The present invention will be described below with reference to exemplary embodiments and the accompanying schematic drawings, in which:
Fig. 1 depicts a lithographic projection apparatus according to an embodiment of the invention;
Fig. 2 shows a part of the measurement station region of the lithographic projection apparatus, including a level sensor;
Fig. 3A shows a side view of a part of a flat substrate with already (partly) processed dies;
Fig. 3B shows a side view of the substrate having an unflatness due to a contamination particle, and shows an imaginary side view of the substrate after subtraction of an average die topology;
Fig 4 shows a flow chart with four top views of the different height maps during the processing of the height map information.

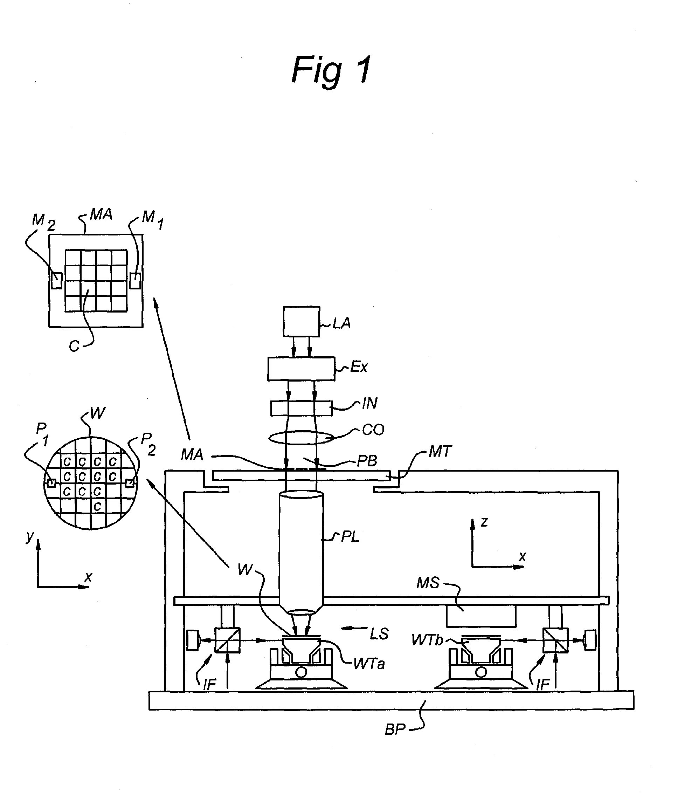

Figure 1 schematically depicts a lithographic projection apparatus according to an embodiment of the invention. The apparatus comprises:
- a radiation system LA, Ex, IN, CO for supplying a projection beam PB of radiation (e.g. UV or EUV radiation);
- a first object table (mask table) MT provided with a mask holder for holding a mask MA (e.g. a reticle), and connected to first positioning means for accurately positioning the mask with respect to item PL;
- a second object table (substrate or wafer table) WTa provided with a substrate holder for holding a substrate W (e.g. a resist-coated silicon wafer), and connected to second positioning means for accurately positioning the substrate with respect to item PL;
- a third object table (substrate or wafer table) WTb provided with a substrate holder for holding a substrate W (e.g. a resist-coated silicon wafer), and connected to third positioning means for accurately positioning the substrate with respect to item PL;
- a measurement system MS for performing measurement (characterization) processes on a substrate held on a substrate table WTa or WTb at a measurement station;
- a projection system ("lens") PL (e.g. a refractive or catadioptric system, a mirror group or an array of field deflectors) for imaging an irradiated portion of the mask MA onto an exposure area C (die) of a substrate W held in a substrate table WTa or WTb at an exposure station.

As here depicted, the apparatus is of a transmissive type (i.e. has a transmissive mask). However, in general, it may also be of a reflective type, for example.

The radiation system comprises a source LA (e.g. a Hg lamp, excimer laser, an undulator provided around the path of an electron beam in a storage ring or synchrotron, a laser plasma source or an electron or ion beam source) which produces a beam of radiation. This beam is passed along various optical components comprised in the illumination system, - e.g. beam shaping optics Ex, an integrator IN and a condenser CO - so that the resultant beam PB has a desired shape and intensity distribution in its cross-section.

The beam PB subsequently intercepts the mask MA which is held in a mask holder on a mask table MT. Having passed through the mask MA, the beam PB passes through the lens PL, which focuses the beam PB onto an exposure area C of the substrate W. With the aid of the interferometric displacement and measuring means IF, the substrate tables WTa, WTb can be moved accurately by the second and third positioning means, e.g. so as to position different exposure areas C in the path of the beam PB. Similarly, the first positioning means can be used to accurately position the mask MA with respect to the path of the beam PB, e.g. after mechanical retrieval of the mask MA from a mask library. In general, movement of the object tables MT, WTa, WTb will be realized with the aid of a long stroke module (course positioning) and a short stroke module (fine positioning), which are not explicitly depicted in Figure 1. In the case of a wafer stepper (as opposed to a step-and-scan apparatus) the reticle table may be connected only to a short stroke positioning device, to make fine adjustments in mask orientation and position.

The second and third positioning means may be constructed so as to be able to position their respective substrate tables WTa, WTb over a range encompassing both the exposure station under projection system PL and the measurement station under the measurement system MS. Alternatively, the second and third positioning means may be replaced by separate exposure station and measurement station positioning systems for positioning a substrate table in the respective exposure stations and a table exchange means for exchanging the substrate tables between the two positioning systems. Suitable positioning systems are described, inter alia, in WO 98/28665 and WO 98/40791 mentioned above. It should be noted that a lithography apparatus may have multiple exposure stations and/or multiple measurement stations and that the numbers of measurement and exposure stations may be different than each other and the total number of stations need not equal the number of substrate tables. Indeed, the principle of separate exposure and measurement stations may be employed even with a single substrate table.

The depicted apparatus can be used in two different modes:
1. In step-and-repeat (step) mode, the mask table MT is kept essentially stationary, and an entire mask image is projected in one go (i.e. a single "flash") onto an exposure area C. The substrate table WT is then shifted in the X and/or Y directions so that a different exposure area C can be irradiated by the beam PB;
2. In step-and-scan (scan) mode, essentially the same scenario applies, except that a given exposure area C is not exposed in a single "flash". Instead, the mask table MT is movable in a given direction (the so-called "scan direction", e.g. the Y direction) with a speed v, so that the projection beam PB is caused to scan over a mask image; concurrently, the substrate table WTa or WTb is moved in the same or opposite direction at a speed V = Mv, in which M is the magnification of the lens PL (typically, M = 1/4 or 1/5). In this manner, a relatively large exposure area C can be exposed, without having to compromise on resolution.

An important factor influencing the imaging quality of a lithographic apparatus is the accuracy with which the mask image is focused on the substrate. In practice, since the scope for adjusting the position of the focal plane of the projection system PL is limited and the depth of focus of that system is small, this means that the exposure area of the wafer (substrate) must be positioned precisely in the focal plane of the projection system PL. To do this, it is of course necessary to know both the position of the focal plane of the projection system PL and the position of the top surface of the wafer. Wafers are polished to a very high degree of flatness but nevertheless deviation of the wafer surface from perfect flatness (referred to as "unflatness") of sufficient magnitude noticeably to affect focus accuracy can occur. Unflatness may be caused, for example, by variations in wafer thickness, distortion of the shape of the wafer or contaminants on the wafer holder. The presence of structures due to previous process steps also significantly affects the wafer height (flatness). Unless the context otherwise requires, references below to "the wafer surface" refer to the top surface of the wafer onto which will be projected the mask image.

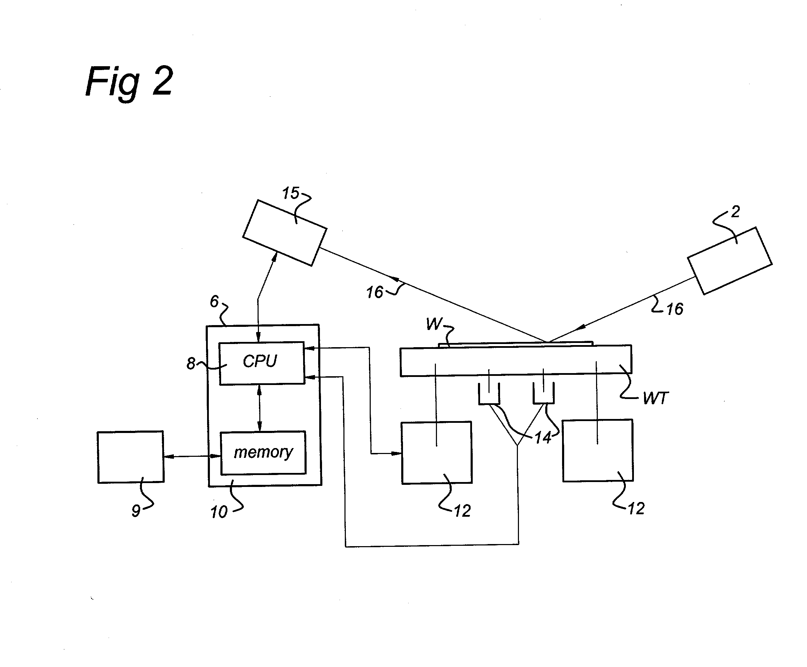

In figure 2, a part of the measurement station region of the lithographic projection apparatus is shown. The substrate W is held on the substrate table WT. The substrate table WT is connected to actuators 12. These actuators 12 are connected to a control device 6 with a processor 8 and a memory 10. The processor 8 further receives information from position sensors 14 measuring the actual position of the wafer table WT or wafer table holder by electric (capacitive, inductive) or optical, e.g. interferometric (as shown in figure 1) means. The processor 8 also receives input from a level sensor LS which measures the height and/or tilt information from the target area on the wafer where the projection beam PB will hit the substrate surface. Preferably, the control device 6 is connected to a reporting system 9, which may comprise a PC or a printer or any other registration or display device.

The level sensor LS may be, for example, an optical sensor; alternatively, a pneumatic or capacitive sensor (for example) is conceivable. A presently preferred form of sensor is an optical sensor making use of Moiré patterns formed between the image of a projection grating reflected by the wafer surface and a fixed detection grating as described in US Patent 5,191,200. The level sensor LS should preferably measure the vertical position of one or more very small areas (e.g. 15 nm) of the wafer surface. The LS shown in figure 2, comprises a light source 2 for producing a light beam 16, projection optics (not shown) for projecting the light beam 16 onto the wafer W, detection optics (not shown) and a detector 15. The detector generates a height dependent signal, which is fed to the processor 8. The processor is arranged to process the height information and to construct a measured height map. Such a height map may be stored by the processor 8 in the memory 10. The term 'height map' is intended to mean a plurality of substrate height measurements, each recorded with associated X and Y co-ordinates.

Figure 2 relates to a multi stage lithographic apparatus. However, according to another embodiment of the invention, the level sensor LS may be present in a single stage lithographic projection apparatus.

The level sensing method uses one or more small areas and measures the average height of the small areas, referred to as sensing spots. Depending on the position of the sensing spots on the wafer area, a selection mechanism selects the spots, which are applicable to derive height and/or tilt information from a measured target area. For example, sensing spots outside the measured target area, will not be selected to derive height information.

If only those sensing spots falling fully within the target area were to be used, less then 100% of the target area would be measured. This would mean that a focus spot might fall within a non-measured area, and would therefore not be detected. A way to solve this problem is by using extra sensing spots which cross the border of the target area. In this way all relevant areas on the wafer are sensed and are available for focus spot detection algorithms.

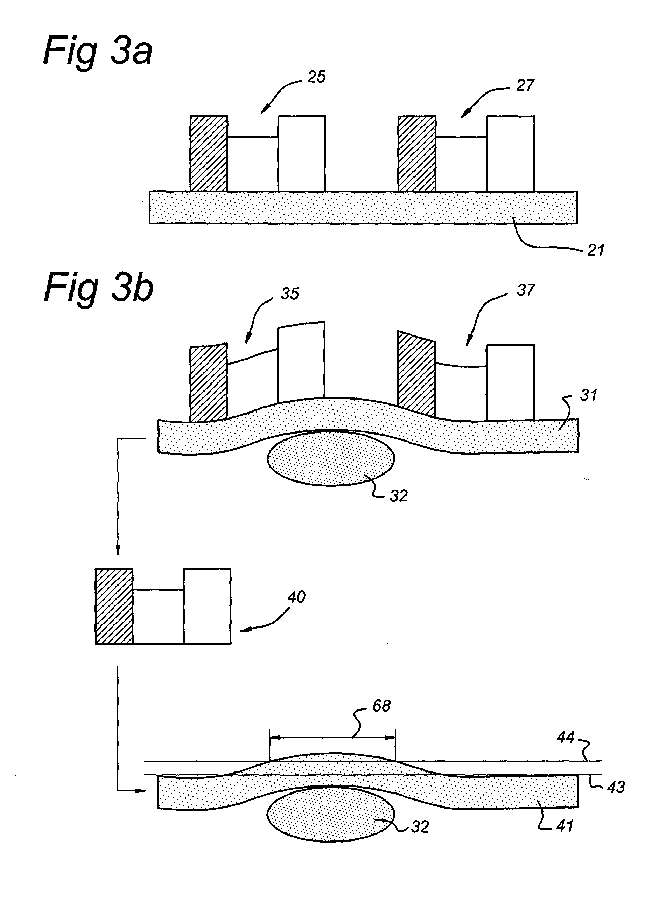

The principle of the present invention is now explained with the help of figures 3A and 3B. Figure 3A shows a side view of a substrate 21 with two structures, representing two dies (target areas) 25, 27. In figure 3A, the substrate 21 is flat, showing no signs of contamination underneath.

Figure 3B however, shows a substrate 31 having an unflatness caused by a contamination particle 32. The contamination particle 32 is situated between a substrate holder, not shown, and the substrate 31. Due to the unflatness of the substrate 31, the surface of the wafer, i.e. the top surfaces of dies 35, 37 laying on top of the substrate 31, also shows an 'unflatness'. In an embodiment of the invention, the processor 8 is arranged to create a measured height map out of height information received from the level sensor LS. Because of the relatively large dimensions of the structures of the dies (i.e. topology), the 'unflatness' is hidden. This means that the measured height map does contain information on the unflatness, but it will be very difficult to accurately locate and register a contamination particle.

According to the invention, the lithographic projection apparatus comprises a processor 8, arranged to calculate an average die topology 40, see figure 3B, and to subtract the average die topology 40 from the measured height map for dies on the substrate, thereby producing a raw height map of the substrate surface. Figure 3B shows the situation after the subtraction. An imaginary substrate 41 is shown, without any die on top. Due to the contamination particle 32, the substrate 41 shows an unflatness. According to an embodiment, a smoothed height map 43 is subtracted from the raw height map. For all positions of the substrate, deviations (i.e. residuals) are calculated, resulting in a 'subtracted height map' of the substrate surface. These residuals are used to determine a standard deviation σ. Next, focus spots are defined as being areas on the substrate 41, in which the residual height is n times higher than σ, with n being an integer or any positive real number. In figure 3B, a threshold line 44 is shown which indicates a height that is n*σ higher than the smoothed height map 43. Areas in which the subtracted height map exceeds the threshold line 44, are defined as focus spots 68. It is appreciated that other mathematical calculations are possible to define the threshold and the focus spots, using said 'subtracted height map'. For example, an absolute threshold Zₘₐₓ may be used to detect focus spots.

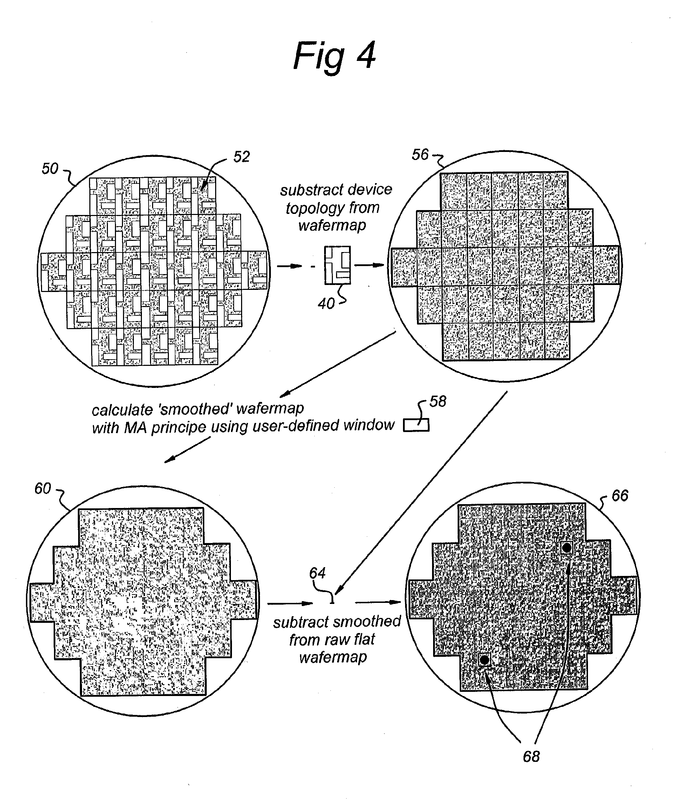

According to an embodiment, the processor 8 is arranged to process the measured height map. Figure 4 shows a flow chart with four top views of the different height maps during the processing of the height map information. A measured height map 50 contains height information of a plurality of points on the substrate. The degree of detail of the height map is dependent on the resolution of the level sensor, which is used to measure the heights of the particular points, as will be clear to a skilled person. The measured height map 50 comprises height information from several dies 52. The processor 8 is arranged to calculate an average die topology, depicted in figure 4 by 40. The average die topology 40 is calculated by adding the height of a particular point (x_{k,}yₖ) within a die k, (where (x_{k,}yₖ) indicates a local co-ordinate within the die), to the height of the corresponding points (x_{k,}yₖ) in the other dies k, with k = 1, 2, .. N wherein N is equal to the number of dies on the substrate. This is done for all points within the dies 52. Then, for all the points (x_{k,}yₖ) within the dies 52, the result of the addition is divided by the number of dies, i.e. N. The result is an average die topology, as shown in figure 2B, and indicated in figure 4 by reference number 40. Next, the average die topology 40 is subtracted from the measured height map 50, at each of the die locations. This results in a raw height map 56 of the substrate surface. Then, the raw height map 56 is smoothed using a moving average principle with a smoothing window 58. According to an embodiment of the invention the processor 8 is arranged to smooth the raw height map by calculating an average height at a point x,y, i.e. AH(x,y), wherein the average height AH(x,y) is equal to the sum of all heights H(xᵢ,yᵢ,) in a window [*(x*-*a*, *y*+*a)*, *(x*-*a*, *y*-*a)*, *(x*+*a*,*y*+*a)*, *(x*+*a,y*-*a)*] divided by the number of points xᵢ,yᵢ in said window, where *a* is the size of said window. The smoothing window 58 is preferably relatively large as compared to the expected focus spots. Typical values of the size of a focus spot is 5 * 5 mm. So preferably, the window is larger than 10 * 10 mm, particularly 15 * 15 mm (i.e. *a* = 7.5 mm). The result of the smoothing of the raw height map 56 is a smoothed height map 60, see figure 4. Then, the smoothed height map 60 is subtracted from the raw height map for every x, y position of the substrate. This is indicated by the '- ' sign 64 in figure 4. These results, in a map called the subtracted height map 66. From this subtracted height map 66 it is possible to locate local unflatnesses (i.e. hills) 68 very easily. If such unflatnesses exceed a predefined deviation threshold F, the areas in which these unflatnesses occur, are labelled as focus spots. In an embodiment of the invention, different deviation thresholds are used to classify, for example, critical and less critical focus spots. In a multi-stage apparatus for example, it is possible to reject a wafer when the wafer comprises (too many) critical focus spots, before the wafer is even processed at the exposure station. This increases yield of the apparatus.

In an embodiment, the processor 8 is arranged to filter out obvious errors such as measurements errors, local dirt on the substrate or a focus spots itself. This is achieved by repeating all actions shown in figure 4 but with a so-called feedback height map (not shown) instead of with a measured height map 50. This feedback height map is fabricated by removing height information from the subtracted height map 66 of dies that overlap with the determined focus spots 68. Next, the feedback height map is used to calculate a corrected average die topology. The corrected average die topology is calculated in the same way as the average die topology 40, shown in figure 4, is calculated. Then, the corrected average die topology is subtracted from the feedback height map for dies on the substrate. This leaves a so-called corrected raw height map of the surface of the substrate. The next action is to smooth the corrected raw height map using a moving average principle, as was done with the raw height map, mentioned above. The result is a corrected smoothed height map. From the corrected raw height map the corrected smoothed height map from is subtracted, thereby producing a corrected subtracted height map. Then, the a deviation threshold F is determined. Next, the focus spots are determined as being areas in which a residual on the corrected subtracted height map is greater than the at least one deviation threshold F. The above actions may be repeated until a certain accuracy level is reached. By removing the height information of the dies that are on top of a focus spot, and repeating the actions mentioned above, the obvious errors are filtered out. By filtering out the obvious errors, a higher degree of accuracy can be reached.

Preferably, before the average die topology is subtracted from the measured height map, a second or third order polynomial fit is subtracted from the measured height map, in order to remove a global shape of said substrate. The global shape of the substrate may blind local focus spot information in the height maps, so subtracting a second or third order polynomial will increase the accuracy. Of course fourth, fifth or even higher order polynomials may be used. The polynomial fit may also be subtracted from the measured height map after the average die topology has been subtracted.

In a method according to an embodiment of the invention, the subtracted height maps of successively provided substrates are compared, to detect correlations in the locations of any unflatnesses that may be indicative of contamination or systematic faults of said second object table. In this way, so-called 'chuck spots' are located, and it may be decided to clean the substrate holder. In order to detect chuck spots, the location of focus spots on successive substrates (on the same chuck) is compared. In this comparison also the size of the focus spots may be taken into account. Two focus spots will then be regarded as being on the same position if they overlap, or nearly overlap. When the number of focus spots on the same position on successive wafers exceeds a certain threshold level, it will then be considered a chuck spot.

Whilst specific embodiments of the invention have been described above, it will be appreciated that the invention may be practiced otherwise than as described. For example, instead of using a rectangular smoothing window, other shapes like circular or oval windows, may be possible. The description is not intended to limit the invention.

## Claims

1. A lithographic projection apparatus comprising:
- a radiation system (LA) for supplying a projection beam of radiation;
- a first object table (MT) provided with a mask holder for holding a mask;
- a second object table (WT) provided with a substrate holder for holding a substrate, said second object table;
- a projection system (PL) for imaging an irradiated portion of the mask onto a target portion of the substrate;
- a level sensor (2, 14, 15) arranged to measure the height of a plurality of points on the surface of a substrate provided with at least one die, and a processor (8) arranged to create a measured height map (50) using input from said level sensor (2, 14, 15), **characterized in that** said processor (8) is also arranged to calculate an average die topology (40) using said measured height map (50), and to subtract said average die topology (40) from said measured height map (50) for dies (52) on said substrate, to produce a raw height map (56) of said surface of said substrate in order to detect any focus spots on said surface of said substrate using said raw height map (56).

2. Apparatus according to claim 1, wherein said processor (8) is arranged to:
- smooth said raw height map using a moving average principle, thereby producing a smoothed height map (60);
- subtract said smoothed height map (60) from said raw height map (56), thereby producing a subtracted height map (66);
- determine at least one deviation threshold F; and
- determine focus spots (68) as being areas in which a residual on said subtracted height map is greater than said at least one deviation threshold F.

3. Apparatus according to claim 2, wherein said at least one deviation threshold F is defined as n ·σ, where n is a predetermined value and σ is a standard deviation of all residuals for every position x, y on said subtracted height map.

4. Apparatus according to claim 2 or 3, wherein said processor (8) is arranged to:
- remove height information from said subtracted height map (66) of dies that overlap with said determined focus spots (68), thereby producing a feedback height map;
- calculate a corrected average die topology using said feedback height map,
- subtract said corrected average die topology from said feedback height map for dies on said substrate, to produce a corrected raw height map of said surface of said substrate;
- smooth said corrected raw height map using a moving average principle, thereby producing a corrected smoothed height map;
- subtract said corrected smoothed height map from said corrected raw height map, thereby producing a corrected subtracted height map;
- determine the at least one deviation threshold F;
- determine the focus spots as being areas in which a residual on said corrected subtracted height map is greater than said at least one deviation threshold F,
- repeat the above actions until a certain accuracy level is reached.

5. Apparatus according to any of claims 2-4, wherein said apparatus comprises a reporting system (9) arranged to report focus spots, for example to a user.

6. Apparatus according to claim 5, wherein said reporting system (9) and said processor (8) are arranged to report different classifications of focus spots.

7. Apparatus according to any of the preceding claims, wherein said processor (8) is arranged to subtract a second or third order polynomial fit from said measured height map, in order to remove a global shape of said substrate.

8. Apparatus according to any of claims 2-7, wherein said processor (8) is arranged to smooth said raw height map by calculating an average height in a point x,y, i.e. AH(x,y), wherein said average height AH(x,y) is equal to the sum of all heights H(xᵢ,yᵢ) in a window [*(x*-*a, y*+*a)*, *(x*-*a,y*-*a)*, *(x+a,y+a)*, *(x+a,y*-*a)*] divided by the number of points xᵢ,yᵢ in said window, where *a* is the size of said window.

9. Apparatus according to any of the preceding claims, wherein said second object table (WT) is movable between an exposure station, at which said projection system (PL) can image said mask portion onto said substrate, and a measurement station, and wherein said apparatus comprises:
- a positioning system for moving said second object table (WT) between said exposure station and said measurement station, and
- a control unit (8) constructed and arranged to control the position of said second object table (WT), during exposure of said target portion, in accordance with said measured height map.

10. A method of manufacturing devices using a lithographic projection apparatus comprising:
- a radiation system for supplying a projection beam of radiation;
- a first object table (MT) provided with a mask holder for holding a mask;
- a second object table (WT) provided with a substrate holder for holding a substrate; and
- a projection system (PL) for imaging irradiated portions of the mask onto target portions of the substrate;
- a level sensor (2, 14, 15) arranged to measure the height of a plurality of points on the surface of a substrate provided with at least one die, and
- a processor (8) arranged to create a measured height map using input from said level sensor,
the method comprising:
- providing a mask bearing a pattern to said first object table (MT);
- providing a substrate having a radiation-sensitive layer to said second object table (WT);
- imaging said irradiated portions of the mask onto said target portions of the substrate; and
- generating, for said substrate, a measured height map (50) indicating the height of a plurality of points on the substrate surface,
**characterized by**:
- calculating an average die topology (40) using said measured height map (50);
- subtracting said average die topology (40) from said measured height map (50) for dies on said substrate, to produce a raw height map (56) of said surface of said substrate in order to detect any focus spots on said surface of said substrate using said raw height map (56).

11. Method according to claim 10, wherein said method comprises the steps of:
- smoothing said raw height map (56) using a moving average principle, thereby producing a smoothed height map (60);
- subtracting said smoothed height map (60) from said raw height map (56), thereby producing a subtracted height map (66);
- determining at least one deviation threshold F; and
- determining focus spots (68) as being areas in which a residual on said subtracted height map (66) is greater than said at least one deviation threshold F.

12. Method according to any of claims 10-11, wherein said providing of a substrate and imaging are repeated to expose a plurality of substrates, said method further comprising:
- comparing the subtracted height maps (66) of successively provided substrates to detect correlations in the locations of any focus spots (68) that may be indicative of contamination or systematic faults of said second object table (WT).
